## Europäisches Patentamt

## European Patent Office

## Office européen des brevets

(11) Publication number: **0 143 624**
**B1**

## EUROPEAN PATENT SPECIFICATION

(45) Date of publication of patent specification: **05.09.90**

(21) Application number: **84308140.7**

(22) Date of filing: **23.11.84**

(51) Int. Cl.⁵: **G 11 C 29/00,** G 11 C 7/00,
G 11 C 11/24

(54) Dynamic semiconductor memory device having divided memory cell blocks.

(30) Priority: **25.11.83 JP 220553/83**

(43) Date of publication of application:
**05.06.85 Bulletin 85/23**

(45) Publication of the grant of the patent:
**05.09.90 Bulletin 90/36**

(84) Designated Contracting States:
**DE FR GB**

(56) References cited:
**EP-A-0 055 129**

**PATENT ABSTRACTS OF JAPAN, vol. 7, no. 253
(P-235)1398r, 10th November 1983; & JP-A-58
137 178**

**PATENT ABSTRACTS OF JAPAN, vol. 7, no. 23
(P-171)1168r, 29th January 1983; & JP-A-57 176
587**

**PATENT ABSTRACTS OF JAPAN, vol. 5, no. 107
(P-70)779r, 11th July 1981; & JP-A-56 51 093**

**PATENT ABSTRACTS OF JAPAN, vol. 2, no. 150
(E-78)9707r, 15th December 1978; & JP-A-53 120
234**

(73) Proprietor: **FUJITSU LIMITED
1015, Kamikodanaka Nakahara-ku
Kawasaki-shi Kanagawa 211 (JP)**

(72) Inventor: **Takemae, Yoshihiro
8-13-24-303, Akasaka
Minato-ku Tokyo 107 (JP)**
Inventor: **Sato, Kimiaki
4-11-35-204, Minami Azabu
Minato-ku Tokyo 106 (JP)**
Inventor: **Nakano, Masao
473-4-506, Hisasue Takatsu-ku
Kawasaki-shi Kanagawa 213 (JP)**
Inventor: **Nakano, Tomio
Shirahatadaijutaku, 12-404 1-11-2, Shirahatadai
Miyamae-ku Kawasaki-shi Kanagawa 213 (JP)**

(74) Representative: **Fane, Christopher Robin King
et al
HASELTINE LAKE & CO. Hazlitt House 28
Southampton Buildings Chancery Lane
London, WC2A 1AT (GB)**

Courier Press, Leamington Spa, England.

## Description

The present invention relates to a dynamic semiconductor memory device having memory cells divided into a plurality of separated blocks, and more particularly, to a semiconductor memory device having a test circuit enabling a simultaneous test for the plurality of blocks.

In recent years, dynamic metal-oxide semiconductor (MOS) random access memories (RAM's) have been enlarged to 1 Mbit. However, as the integration density of devices has increased, so has a test time period for such devices also increased. Particularly, in a RAM having a small number of output bits, the test time period thereof is remarkably increased.

On the other hand, as the integration density has become higher, the number of memory cells connected to one sense amplifier for the read operation has become higher and, accordingly, the load of each sense amplifier has also become higher so as to reduce the speed of the read operation. In order to reduce the load of each sense amplifier, two or more series of sense amplifiers are provided. That is, the memory cells, sense amplifiers, row address decoders, and the like are divided into two or more blocks. However, such division can increase the time needed to test the memory device (see EP—A—0 055 129).

JP—A—56 51 093 discloses a storage device divided into separate blocks. To reduce the number of write cycles and to decrease the write-in time, data can be written simultaneously into the separate blocks. Data from an I/O section is written into one block, whilst data from a pre-storage circuit is written into another block. Data is stored from the I/O section into the pre-storage circuit.

JP—A—58 137 178 provides for data to be written simultaneously into different sub-blocks.

JP—A—54 120 234 discloses that, to shorten test time, a memory cell array is divided into blocks in a test mode. In this test mode, the same data is written simultaneously into different blocks.

According to the present invention there is provided a dynamic semiconductor memory device comprising a plurality of separate blocks of memory cells, which blocks are provided with respective write circuits for writing data into those blocks, and with respective data output circuits for storing data read out from those blocks, which data output circuits have respective "true" output signal lines and respective "complementary" output signal lines; characterised in that

selectively operable simultaneous write enable circuitry is connected to the said write circuits for causing respective write operations to be performed thereby simultaneously upon the said blocks of memory cells, to write the same test data into each of the said blocks, in a test operation mode of the device, and in that

first output circuitry connected to be driven by said "true" output signal lines, and second output circuitry connected to be driven by said "complementary" output signal lines, are operable in the test operation mode of the device in response to simultaneous read out of the test data from the said blocks to effect respective comparisons

(a) of the levels of the "true" output signal lines relating to respective blocks, and

(b) of the levels of the "complementary" output signal lines relating to respective blocks, and are operable to provide the results of the respective comparisons as first and second logic level outputs, which differ when both comparisons indicate that data as read out from respective blocks is indentical, but which are the same when either comparison indicates a difference between data as read out from respective blocks.

An embodiment of the present invention can provide a semiconductor memory device having memory cells divided into a plurality of blocks, a means for writing data in parallel into the plurality of blocks and a means for comparing data read out of the plurality of blocks. As a result, it is possible to test in parallel a number of bits of memory cell larger than the number of bits in use during a normal operation mode. Accordingly, the time period therefor can be reduced significantly as compared with a prior art device.

Reference will now be made, by way of example, to the accompanying drawings, wherein:

Fig. 1 is a circuit diagram of a prior art dynamic RAM;

Fig. 2 is a circuit diagram of a data output amplifier of Fig. 1;

Fig. 3 is a circuit diagram of a dynamic RAM embodying the present invention;

Fig. 4 is a table diagram of ouputs from output comparison circuitry of Fig. 3;

Fig. 5 is a circuit diagram of a modification of simultaneous write enable circuitry of Fig. 3;

Fig. 6 is a circuit diagram of a modification of output comparison circuitry of Fig. 3;

Fig. 7 is a table diagram of outputs from the output comparison circuitry of Fig. 6;

Fig. 8 is a circuit diagram of another modification of the output comparison circuitry of Fig. 3;

Fig. 9 is a circuit diagram of still another modification of the output comparison circuitry of Fig. 3; and

Fig. 10 is a circuit diagram of additional circuitry for a test pad of Fig. 3.

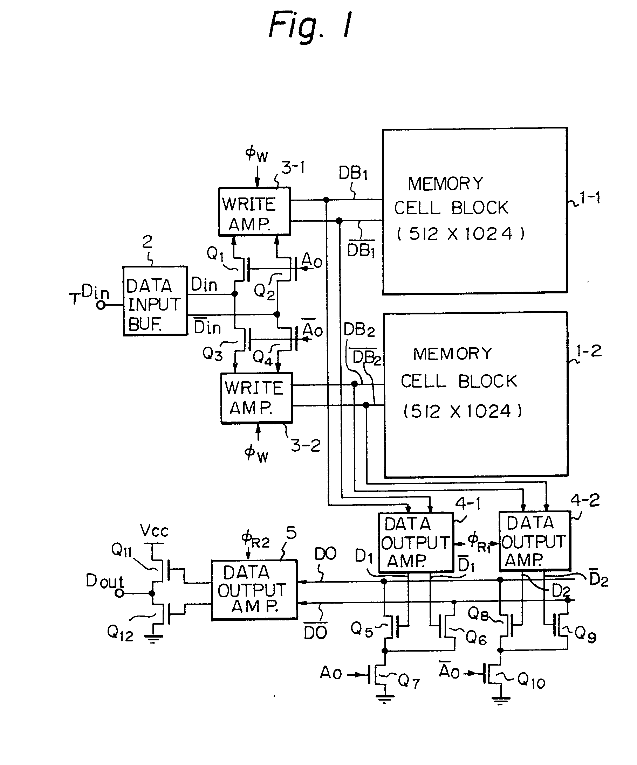

In Fig. 1, which illustrates a prior art dynamic RAM, 1 Mbit memory cells are divided into two 512 kbit memory cell blocks 1-1 and 1-2. In order to perform a write operation upon a memory cell of the memory cell blocks 1-1 and 1-2, a data input buffer 2, write amplifiers 3-1 and 3-2 clocked by a clock signal $\phi_W$, and transistors $Q_1$ through $Q_4$ are provided. The data input buffer 2 receives an input data signal $_TD_{In}$ of a transistor-transistor logic (TTL) level, and, as a result, generates an input data signal $D_{In}$ of a metal-oxide semiconductor (MOS) level and its inverted signal. The input data signals $D_{In}$ and $\overline{D}_{In}$ are supplied via the transistors $Q_1$ and $Q_2$ to the write amplifiers 3-1, and in addition, are supplied via the transistors $Q_3$ and $Q_4$ to the write amplifier 3-2. In this case, the transistors $Q_1$ and $Q_4$ are controlled by one bit of row address signals such as an upper bit $A_0$, while the transistors $Q_3$ and $Q_4$ are controlled by its inverted signal $\overline{A}_0$. For example, when the potential of the address signal $A_0$ is high, the data signals $D_{in}$ and $\overline{D}_{in}$ are transmitted via the transistors $Q_1$ and $Q_2$ to the write amplifier 3-1. One memory cell is then selected within the memory cell block 1-1 by the row and column address decoders, not shown, and a write operation of data from the write amplifier 3-1 is performed upon the selected memory cell by using data buses $DB_1$ and $\overline{DB}_1$. Contrary to this, when the potential of address signal $A_0$ is low, and accordingly, the potential of the address signal $\overline{A}_0$ is high, the data signals $D_{in}$ and $\overline{D}_{in}$ are transmitted via the transistors $Q_3$ and $Q_4$ to the write amplifier 3-2. One memory cell is then selected within the memory cell block 1-2 by the row and column address decoders, not shown, and a write operation of data from the write amplifier 3-2 is performed upon the selected memory cell by using data buses $DB_2$ and $\overline{DB}_2$.

Thus, a write operation is performed upon only one block, i.e., one of the memory cell blocks 1-1 and 1-2.

In order to perform a read operation upon a memory cell of the memory cell blocks 1-1 and 1-2, two data ouput amplifiers 4-1 and 4-2 clocked by a clock signal $\phi_{R1}$, transistors $Q_5$ through $Q_{12}$, and a data output buffer 5 clocked by a clock signal $\phi_{R2}$ are provided. The transistors $Q_5$, $Q_6$, and $Q_7$ serve as a selection circuit for selectively connecting the outputs $D_1$ and $\overline{D}_1$ of the data output amplifier 4-1 to data output buses DO and $\overline{DO}$, while the transistors $Q_8$, $Q_9$, and $Q_{10}$ serve as a selection circuit for selectively connecting the outputs $D_2$ and $\overline{D}_2$ of the data output amplifier 4-2 to the data output buses DO and $\overline{DO}$. The potentials of the data output buses DO and $\overline{DO}$ are transmitted via the data output buffer 5 to the transistors $Q_{11}$ and $Q_{12}$ which serve as a data output buffer.

The transistor $Q_7$ is controlled by the address signal $A_0$, while the transistor $Q_{10}$ is controlled by the address signal $\overline{A}_0$. Therefore, only one of the data ouput amplifiers 4-1 and 4-2 is selectively connected to the data output buses DO and $\overline{DO}$. For example, when the address signal $A_0$ is high, the transistor $Q_7$ is turned on, so that one of the transistors $Q_5$ and $Q_6$ is turned on and the other is turned off. As a result, the outputs $D_1$ and $\overline{D}_1$ are transmitted via the transistors $Q_5$ and $Q_6$ to the data output buses DO and $\overline{DO}$. Contrary to this, when the address signal $A_0$ is low, and accordingly, the address signal $\overline{A}_0$ is high, the transistor $Q_{10}$ is turned on, so that one of the transistors $Q_8$ and $Q_9$ is turned on and the other is turned off. As a result, the outputs $D_2$ and $\overline{D}_2$ are transmitted via the transistors $Q_8$ and $Q_9$ to the data output buses DO and $\overline{DO}$.

Thus, in the device of Fig. 1, during a write mode, input data $D_{in}$ is written into one memory cell of a memory cell block selected by the address signals $A_0$ and $\overline{A}_0$, and during a read mode, data is read out of one memory cell of a memory cell block selected by the address signals $A_0$ and $\overline{A}_0$. Therefore, in the testing of the device of Fig. 1, input data is sequentially written into each of the memory cells, and it is determined whether or not a writing and reading operation is normally carried out by comparing output data with the input data. As a result, the test time period becomes remarkably long, particularly in the case of a high-integrated capacity of a memory device.

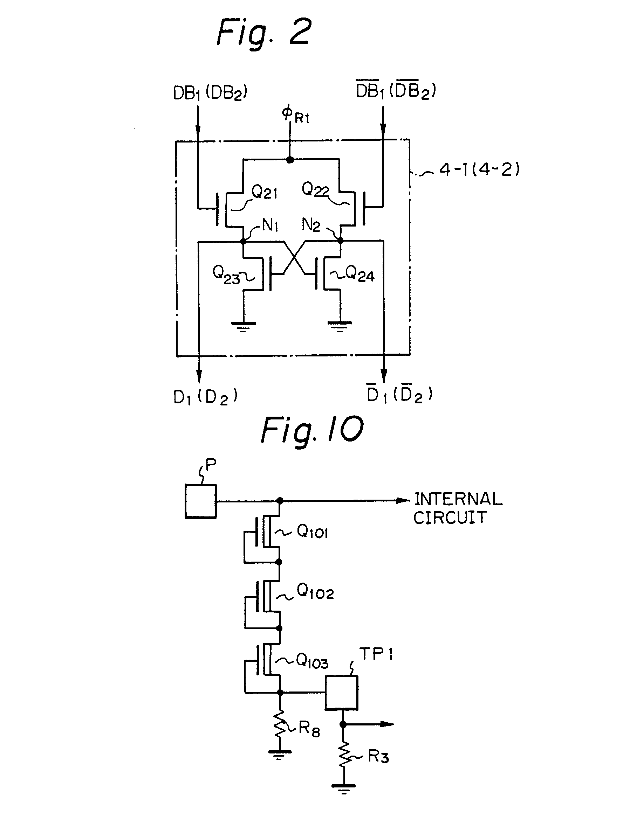

Note that each of the data output amplifiers 4-1 and 4-2 is fully illustrated in Fig. 2. That is, each of the data output amplifiers 4-1 and 4-2 comprises two transistors $Q_{21}$ and $Q_{22}$ clocked by the clock signal $\phi_{R1}$ and controlled by the potentials at the data buses $DB_1$ and $\overline{DB}_1$ (or $DB_2$ and $\overline{DB}_2$), and further comprises two cross-coupled transistors $Q_{23}$ and $Q_{24}$ which form a flip-flop. The potentials at nodes $N_1$ and $N_2$ are transmitted as the outputs $D_1$ and $\overline{D}_1$ (or $D_2$ and $\overline{D}_2$) to the gates of the transistors $Q_5$ and $Q_6$ (or $Q_8$ and $Q_9$). Also, the data output buffer 5 has the same configuration as the circuit of Fig. 2.

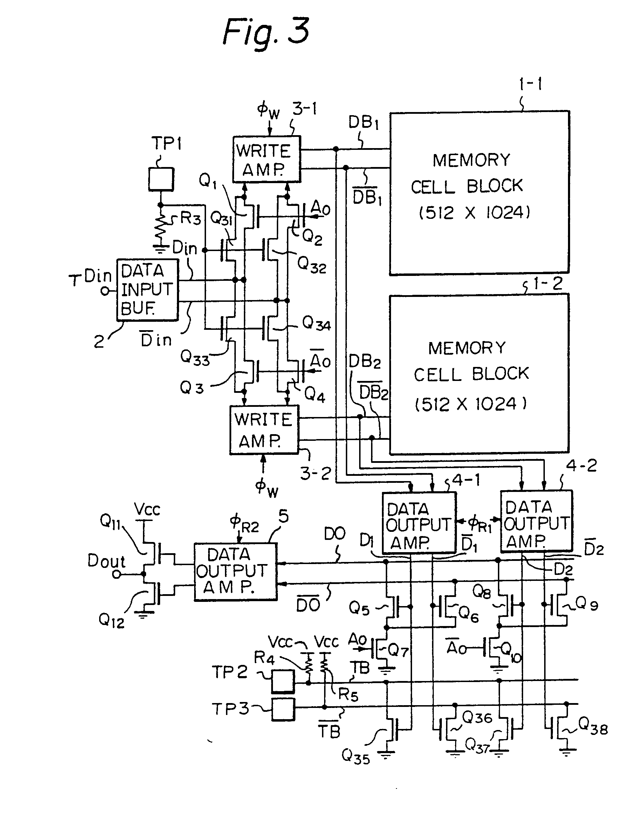

In Fig. 3, which illustrates an embodiment of the present invention, a test pad TP1, a pulling-down resistor $R_3$, and transistors $Q_{31}$, $Q_{32}$, $Q_{33}$, and $Q_{34}$ are added to the elements of the device of Fig. 1, thereby performing a write operation of the same input data $D_{in}$ upon both of the blocks, i.e., both of the memory cell blocks 1-1 and 1-2, simultaneously. That is, the elements TP1, $R_3$, $Q_{31}$, $Q_{32}$, $Q_{33}$, and $Q_{34}$ form a simultaneous write enable circuit for the memory cell blocks 1-1 and 1-2. In addition, transistors $Q_{35}$, $Q_{36}$, $Q_{37}$, and $Q_{38}$, pulling-up resistors $R_4$ and $R_5$, and test pads TP2 and TP3 are added to the elements of the device of Fig. 1, thereby comparing the outputs $D_1$ and $\overline{D}_1$ of the data output amplifier 4-1 with the outputs $D_2$ and $\overline{D}_2$ of the data output amplifier 4-2. That is, the elements $Q_{35}$, $Q_{36}$, $Q_{37}$, $Q_{38}$, $R_4$, $R_5$, TP2, and TP3 form a comparison circuit for the outputs of the memory cell blocks 1-1 and 1-2.

During a normal operation mode, the potential at the test pad TP1 is in an open state, so that the charge at the test pad TP1 is discharged. As a result, all the transistors $Q_{31}$, $Q_{32}$, $Q_{33}$ and $Q_{34}$ are cut off. Therefore, the device of Fig. 3 operates in the same way as the device of Fig. 1. Of course, in this case, the output comparison circuit formed by the elements $Q_{35}$, $Q_{36}$, $Q_{37}$, $Q_{38}$, $R_4$, $R_5$, TP2, and TP3 does not affect the normal operation.

During a test operation mode, a high potential is applied to the test pad TP1, so that the transistors $Q_{31}$, $Q_{32}$, $Q_{33}$, and $Q_{34}$ are turned on. As a result, the input data $D_{in}$ is supplied to the write amplifiers 3-1 and 3-2, and accordingly, the input data $D_{in}$ is written into one memory cell of each memory cell block 1-1 and 1-2. The selection of this one memory cell is carried out by the row and column address decoders (not shown).

Note that the pulling-down resistor $R_3$ linked between the test pad TP1 and the ground is provided for pulling down the potential at the test pad TP1 to a low level when the test pad 1 is in an open state.

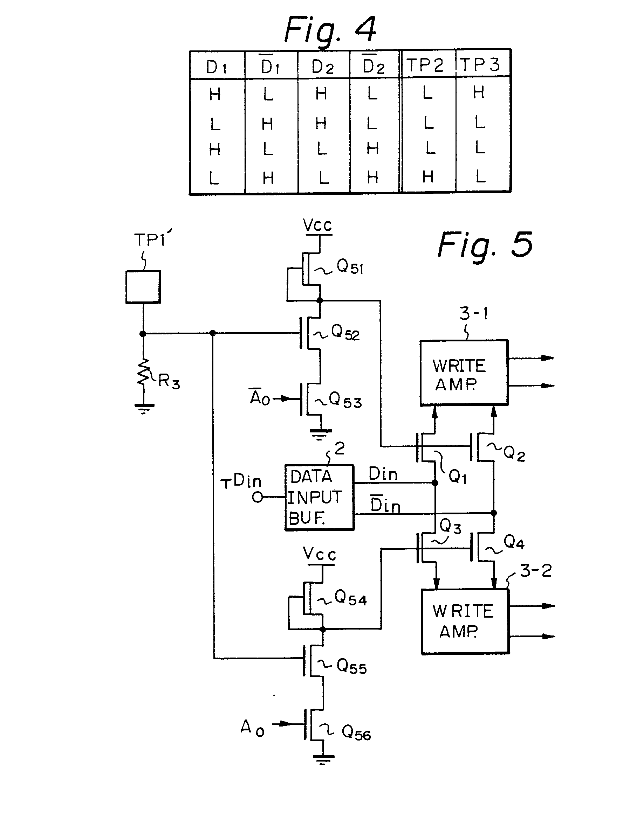

Thus, after the same input data $D_{In}$ is written into the two memory blocks 1-1 and 1-2, data is read out of each of the memory cell blocks 1-1 and 1-2, and is stored in each of the data output amplifiers 4-1 and 4-2. The outputs $D_1$ and $\overline{D}_1$ of the data output amplifier 4-1 are applied to the gates of the transistors $Q_{35}$ and $Q_{36}$, while the outputs $D_2$ and $\overline{D}_2$ of the data output amplifier 4-2, are applied to the gates of the transistors $Q_{37}$ and $Q_{38}$. At this time, when the outputs $D_1$ and $\overline{D}_1$ are the same as the outputs $D_2$ and $\overline{D}_2$, respectively, signals having different polarities are generated at the test pads TP2 and TP3 via test buses TB and $\overline{TB}$. Referring to Fig. 4, if the outputs $D_1$ and $D_2$ are both at a high level (H) and the outpus $\overline{D}_1$ and $\overline{D}_2$ are both at a low level (L), the transistors $Q_{35}$ and $Q_{37}$ are turned on and the transistors $Q_{36}$ and $Q_{38}$ are cut off. As a result, the potentials at the test pads TP2 and TP3 are at a low level and at a high level respectively. Similarly, if the outputs $D_1$ and $D_2$ are both at a low level, and the outputs $\overline{D}_1$ and $\overline{D}_2$ are both at a high level, the transistors $Q_{36}$ and $Q_{38}$ are turned on and the transistors $Q_{35}$ and $Q_{37}$ are cut off. As a result, the potentials at the test pads TP2 and TP3 are at a high level and at a low level, respectively.

Contrary to the above, if the outputs $D_1$ and $\overline{D}_1$ of the data output amplifier 4-1 are different from the outputs $D_2$ and $\overline{D}_2$ of the data output amplifier 4-2, the potentials at the test pads TP2 and TP3 are both at a low level, as shown in Fig. 4. For example, if the outputs $D_1$ and $\overline{D}_1$ are at a high level and at a low level, respectively, and the outputs $D_2$ and $\overline{D}_2$ are at a low level and at a high level, respectively, the transistors $Q_{35}$, and $Q_{38}$ are both turned on and the transistors $Q_{36}$ and $Q_{37}$ are cut off, and accordingly, the potentials at the test pads TP2 and TP3 are both at a low level.

Thus, the state wherein the potentials at the test pads TP2 and TP3 are both low exhibits an error state; i.e., one of the memory cell blocks 1-1 and 1-2 is erroneously operated.

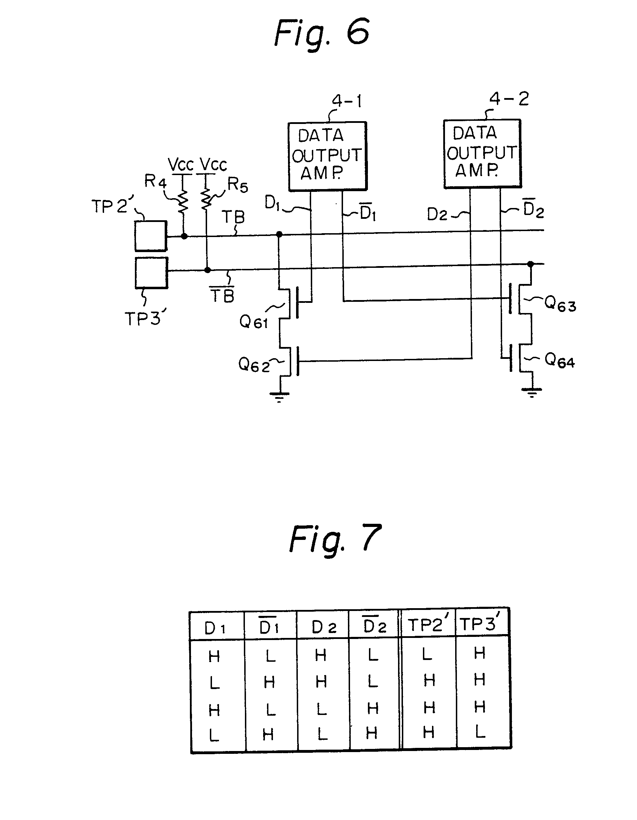

In Fig. 5, which is a modification of the simultaneous write enable circuit of Fig. 3, the gate potentials of the transistors $Q_1$, $Q_2$, $Q_3$, and $Q_4$ are controlled, thereby switching the normal operation mode and the test operation mode. For this purpose, a depletion-type transistor $Q_{51}$, enhancement-type transistors $Q_{52}$ and $Q_{53}$, a depletion-type transistor $Q_{54}$, enhancement-type transistors $Q_{55}$ and $Q_{56}$, and a test pad TP1' are provided. In this case, the transistors $Q_{51}$, $Q_{52}$, and $Q_{53}$ form a NAND circuit, and the transistors $Q_{54}$, $Q_{55}$, $Q_{56}$ also form a NAND circuit.

During a normal operation mode, the potential at the test pad TP1' is high, so that NAND circuit formed by the transistors $Q_{51}$, $Q_{52}$, and $Q_{53}$ serves as an inverter for the address signal $\overline{A}_0$, and the NAND circuit formed by the transistors $Q_{54}$, $Q_{55}$, and $Q_{56}$ also serves as an inverter for the address signal $A_0$. Therefore, the circuit of Fig. 5 operates in the same way as the device of Fig. 1.

On the other hand, during a test operation mode, the test pad TP1' is in an open state, so that the charge of the test pad TP1' is discharged via the resistor $R_3$, thereby decreasing the potential at the test pad TP1'. As a result, the transistors $Q_{52}$ and $Q_{55}$ are both cut off, and the gate potentials of the transistors $Q_1$, $Q_2$, $Q_3$, and $Q_4$ remain high, by the depletion-type transistors $Q_{51}$ and $Q_{54}$. As a result, the input data $D_{In}$ is supplied to the write amplifiers 3-1 and 3-2, and accordingly, the input data $D_{In}$ is written into one memory cell of each memory cell block 1-1 and 1-2.

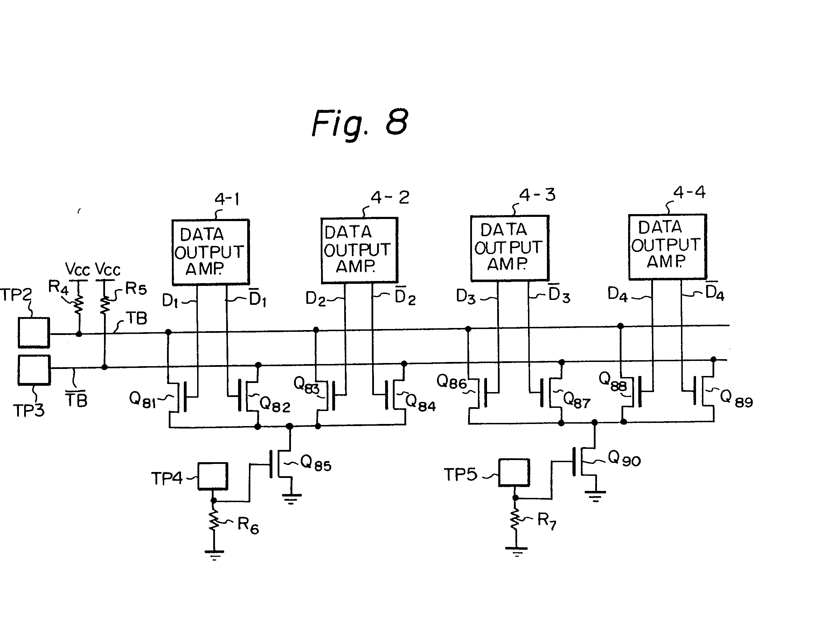

In Fig. 6, which is modification of the output comparison circuit of Fig. 3, transistors $Q_{61}$ and $Q_{62}$ are provided in series, and transistors $Q_{63}$ and $Q_{64}$ are also provided in series. The operation of the circuit of Fig. 6 is shown in a truth table of Fig. 7. This table shows that the state wherein the potentials at the test pads TP2' and TP3' are both high exhibits an error state; i.e., one of the memory cell blocks 1-1 and 1-2 is erroneously operated. Note that, if there are more than three data output amplifiers, i.e., more than three memory cell blocks, it is possible to carry out an output comparison thereupon by increasing the number of transistors connected in series.

In Fig. 8, which is another modification of the output comparison circuit of Fig. 3, transistors $Q_{81}$ through $Q_{90}$, test pads TP4 and TP5, and pulling-down resistors $R_6$ and $R_7$, are provided for four data output amplifiers 4-1 through 4-4. The transistors $Q_{81}$ through $Q_{84}$ correspond to the transistors $Q_{35}$ through $Q_{38}$ of Fig. 3, respectively, and the transistors $Q_{86}$ through $Q_{89}$ also correspond to the transistors $Q_{35}$ through $Q_{38}$ of Fig. 3, respectively. When a common test is required for all the data output amplifiers 4-1 through 4-4, a high potential is applied to both of the test pads TP4 and TP5. Contrary to this, when a partial test is required for the data output amplifiers 4-1 and 4-2, a high potential is applied to only the test pad TP4.

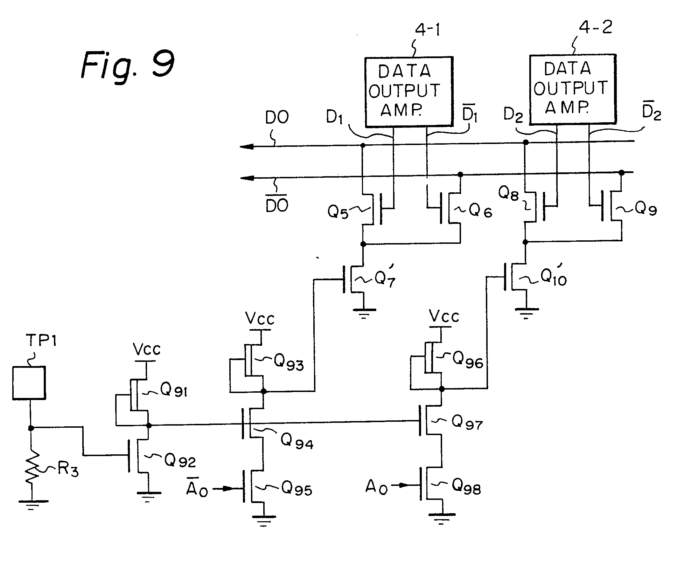

In Fig. 9, which is still another modification of the output comparison circuit of Fig. 3, the data output buses DO and $\overline{DO}$ also serve as test buses TB and $\overline{TB}$, and accordingly, the test pads TP2 and TP3 (or TP2' and TP3') are not provided. Therefore, the result of the output comparison circuit is obtained at the output of the output buffer formed by the transistors $Q_{11}$ and $Q_{12}$ of Fig. 3. In Fig. 9, transistors $Q_7'$ and $Q_{10}'$, which correspond to the transistors $Q_7$ and $Q_{10}$, respectively, are provided. However, the gate potentials of the transistors $Q_7'$ and $Q_{10}'$ are controlled by a circuit formed by transistors $Q_{91}$ through $Q_{98}$ and the test pad TP1 and the pulling-down resistor $R_3$. In this case, the transistors $Q_{91}$ and $Q_{92}$ serve as an inverter. In addition, the transistors $Q_{93}$, $Q_{94}$, and $Q_{95}$ form a NAND circuit, and the transistors $Q_{96}$, $Q_{97}$, $Q_{98}$ also form a NAND circuit. Note that the test pad TP1 and the pulling-down resistor $R_3$ are the same as those of Fig. 3.

During a normal operation mode, the test pad TP1 is in an open state, so that the charge of the test pad TP1 is discharged via the resistor $R_3$

thereby decreasing the potential at the test pad TP1. As a result, the inverter formed by the transistors $Q_{91}$ and $Q_{92}$ generates a high potential. Therefore, the NAND circuit formed by the transistors $Q_{93}$, $Q_{94}$, and $Q_{95}$ serves as an inverter for the address signal $\bar{A}_0$, and the NAND circuit formed by the transistors $Q_{96}$, $Q_{97}$, and $Q_{98}$ also serves as an inverter for the address signal $A_0$. Therefore, the circuit of Fig. 9 operates in the same way as the device of Fig. 1.

On the other hand, during a test operation mode, a high potential is applied to the test pad TP1. As a result, the inverter formed by the transistors $Q_{91}$ and $Q_{92}$ generates a low potential, and accordingly, the transistors $Q_{94}$ and $Q_{97}$ are cut off. Therefore, the gate potentials of the transistors $Q_7{}'$ and $Q_{10}{}'$ remain high, by the depletion-type transistors $Q_{93}$ and $Q_{96}$. Thus, in this case, the data output buses DO and $\overline{DO}$ serve as the test buses TB and $\overline{TB}$ of Fig. 3. That is, the state wherein the potentials at the data output buses DO and $\overline{DO}$ are both low exhibits an error state; i.e., one of the memory cell blocks 1-1 and 1-2 (Fig. 3) is erroneously operated. Note that when the potentials at the data output buses DO and $\overline{DO}$ are both low, the output $D_{out}$ of the data output buffer formed by the transistors $Q_{11}$ and $Q_{12}$ reaches a high impedance state.

In Fig. 10, which is an additional circuit for a test pad such as TP1, the test pad TP1 is connected via depletion-type transistors $Q_{101}$, $Q_{102}$, and $Q_{103}$, and a resistor $R_8$ to a pad P for a normal operation. Such a pad P is connected to a lead pin by wire bonding or the like in assembling processes. Note that the above-mentioned test pads are usually provided inside of the memory device, and accordingly, the test pads are sealed after the completion of the memory device. Therefore, if it is required to test the memory device even after the completion thereof, it is possible to do so by connecting the test pads via inverters or the like to the pads for use in a normal operation.

In an embodiment of the present invention, since a plurality of blocks of memory cells can be tested simultaneously, a test for a large capacity memory device can be carried out in a very short time period.

It will accordingly be appreciated that an embodiment of the present invention may advantageously provide a dynamic semiconductor memory device comprising a plurality of blocks of memory cells, said blocks being separated from each other; a plurality of write means, each provided for one of sid memory cell blocks, for writing data thereinto; a simultaneous write enable circuit, connected to said write means, for simultaneously performing a write operation via said plurality of write means upon said plurality of memory cell blocks; a plurality of data output means, each provided for one of said memory cell blocks, for storing data read out of said memory cell blocks, each of said data outpout means having true and complementary output signal lines; a pair of output means, one of said output means being driven by the true signal lines of said data output means, the other being driven by the complementary signal lines of said data output means; and a means, connected to said pair of output means, for transmitting the logic level of said pair of output means to the exterior.

**Claims**

1. A dynamic semiconductor memory device comprising a plurality of separate blocks (1-1, 1-2) of memory cells, which blocks are provided with respective write circuits (3-1, 3-2) for writing data into those blocks, and with respective data output circuits (4-1, 4-2) for storing data read out from those blocks, which data output circuits have respective "true" output signal lines ($D_1$, $D_2$) and respective "complementary" output signal lines ($\bar{D}_1$, $\bar{D}_2$); characterised in that

selectively operably simultaneous write enable circuitry (TP1, $R_3$, $Q_{31}$—$Q_{34}$; TP1', $R_3$, $Q_{51}$ to $Q_{56}$); is connected to the said write circuits (3-1, 3-2) for causing respective write operations to be performed thereby simultaneously upon the said blocks (1-1, 1-2) of memory cells, to write the same test data into each of the said blocks (1-1, 1-2), in a test operation mode of the device, and in that

first output circuitry ($Q_{35}$, $Q_{37}$, TB, $R_4$, TP2; $Q_{61}$, $Q_{62}$, TB, $R_4$, TP2'; $Q_{81}$, $Q_{83}$, TB, $R_4$, TP2; $Q_5$, $Q_8$, DO) connected to be driven by said "true" output signal lines ($D_1$, $D_2$), and second output circuitry ($Q_{36}$, $Q_{38}$, $\overline{TB}$, $R_5$, TP3; $Q_{63}$, $Q_{64}$ $\overline{TB}$, $R_5$, TP3'; $Q_{82}$, $Q_{84}$, $\overline{TB}$, $R_5$, TP3; $Q_6$, $Q_9$, $\overline{DO}$) connected to be driven by said "complementary" output signal lines ($\bar{D}_1$, $\bar{D}_2$), are operable in the test operational mode of the device in response to simultaneous read out of the test data from the said blocks to effect respective comparisons

(a) of the levels of the "true" output signal lines ($D_1$, $D_2$) relating to respective blocks (1-1, 1-2) and

(b) of the levels of the "complementary" output ($\bar{D}_1$, $\bar{D}_2$) signal lines relating to respective blocks (1-1, 1-2), and

are operable to provide the results of the respective comparisons as first and second logic level outputs, which differ when both comparisons indicate that data as read out from respective blocks (1-1, 1-2) is identical, but which are the same when either comparison indicates a difference between data as read out from respective blocks (1-1, 1-2).

2. A device as claimed in claim 1, including a data input buffer (2) for deriving from a primary input data signal ($_T D_{in}$), of a TTL level, a first MOS-level data signal ($D_{in}$) and a second MOS-level data signal ($\bar{D}_{in}$) which is the inverse of the first, a first plurality of transfer gate components ($Q_1$, $Q_3$) which are actuable by respective address signals ($A_0$, $\bar{A}_0$) and are connected for delivering the said first MOS-level data signal ($D_{in}$) respectively to the said write circuits (3-1, 3-2), and a second plurality of transfer gate components ($Q_2$, $Q_4$) which are actuable respectively by the said address signals ($A_0$, $\bar{A}_0$) and are connected for delivering the said second MOS-level data signal ($\bar{D}_{in}$) to the said write circuits (3-1, 3-2).

3. A device as claimed in claim 2, wherein the said simultaneous write enable circuitry comprises first auxiliary transfer gate means ($Q_{31}$, $Q_{33}$), connected in parallel with the said first plurality of transfer gate components ($Q_1$, $Q_3$), second auxiliary transfer gate means ($Q_{32}$, $Q_{34}$), connected in parallel with the said second plurality of transfer gate components ($Q_2$, $Q_4$), and selectively operable actuating means (TP1, $R_3$) connected with the said first and second auxiliary transfer gate means ($Q_{31}$—$Q_{34}$) for actuating them simultaneously.

4. A device as claimed in claim 3, wherein the said selectively operable actuating means comprises pulling-down means ($R_3$) connected to a test pad (TP1) which is connected to the said first and second transfer gate means ($Q_{31}$—$Q_{34}$) so that an actuating potential can be applied thereto by way of the said test pad (TP1).

5. A device as claimed in claim 1, including a data input buffer (2) for receiving an input data signal ($_TD_{in}$) of a TTL level and generating an input data signal ($D_{in}$) of a MOS level and its inverted signal ($\overline{D}_{in}$); and a plurality of transfer gate means ($Q_1$—$Q_4$), each linked between said data input buffer (2) and one of said write circuits (3-1, 3-2); wherein said simultaneous write enable circuitry comprises a test pad (TP1'); a pulling-down means ($R_3$) connected to said test pad (TP1'); and a plurality of NAND gate means ($Q_{51}$—$Q_{53}$, $Q_{54}$—$Q_{56}$), each having an input connected to said test pad (TP1'), an input for receiving the respective one ($A_0$, $\overline{A}_0$) of address signals, and an output connected to one of said transfer gate means ($Q_1$—$Q_4$), thereby activating said transfer gate means ($Q_1$—$Q_4$).

6. A device as claimed in any preceding claim, wherein said first and second output circuitries comprise each:
a test pad (TP2; TP3);
a pulling-up means ($R_4$; $R_5$) connected to the test pad (TP2; TP3) and to a first power supply terminal ($V_{cc}$); and
transfer gate means ($Q_{35}$, $Q_{37}$; $Q_{36}$, $Q_{38}$), connected to the test pad (TP2, TP3) and to a second power supply terminal (GND);
and wherein the transfer gate means ($Q_{35}$, $Q_{37}$) of the first output circuitry are controlled by said "true" output signal lines ($D_1$, $D_2$) and the transfer gate means ($Q_{36}$, $Q_{38}$) of the second output circuitry are controlled by said "complementary" output signal lines ($\overline{D}_1$, $\overline{D}_2$).

7. A device as claimed in any one of claims 1 to 5, wherein said first and second output circuitries comprise each:
a test pad (TP2'; TP3');
a pulling-up means ($R_4$; $R_5$) connected to the test pad (TP2'; TP3') and to a first power supply terminal ($V_{cc}$); and
transfer gate means ($Q_{61}$, $Q_{62}$; $Q_{63}$, $Q_{64}$) connected to the test pad (TP2'; TP3') and to a second power supply terminal (GND), and comprising a plurality of gates ($Q_{61}$, $Q_{62}$; $Q_{63}$, $Q_{64}$) in series;
and wherein the transfer gate means ($Q_{61}$, $Q_{62}$) of the first output circuitry are controlled by said "true" output signal lines ($D_1$, $D_2$) and the transfer gate means ($Q_{63}$, $Q_{64}$) of the second output circuitry are controlled by said "complementary" output signal lines ($\overline{D}_1$, $\overline{D}_2$).

8. A device as claimed in any one of claims 1 to 5, wherein said first and second output circuitries comprise each:
a test pad (TP2; TP3);
a pulling-up means ($R_4$; $R_5$) connected to the test pad (TP2, TP3) and to a first power supply terminal ($V_{cc}$);
and transfer gate means ($Q_{81}$, $Q_{83}$; $Q_{86}$, $Q_{88}$; $Q_{82}$, $Q_{84}$; $Q_{87}$, $Q_{89}$) connected to the test pad (TP2; TP3);
and wherein the transfer gate means ($Q_{81}$, $Q_{83}$; $Q_{86}$, $Q_{88}$) of the first output circuitry are controlled by said "true" output signal lines ($D_1$, $D_2$) and the transfer gate means ($Q_{82}$, $Q_{84}$; $Q_{87}$, $Q_{89}$) of the second output circuitry are controlled by said "complementary" output signal lines ($\overline{D}_1$, $\overline{D}_2$), and
wherein there are further provided selective activation means (TP4, $R_6$, $Q_{85}$; TP5, $R_7$, $Q_{90}$) connected in common to transfer gate means of the first and second output circuitry and to a second power supply terminal (GND), for selectively activating those transfer gate means.

9. A device as claimed in claim 8, wherein the selective activation means comprises a test pad (TP4, TP5), pulling-down means ($R_6$ $R_7$) connected to the test pad (TP4, TP5), and a transfer gate connected to the test pad (TP4, TP5) and between the second power supply terminal (GND) and the transfer gate means of the first and second output circuitries.

10. A device as claimed in claim 4, 5, 6, 7, 8 or 9, wherein each test pad is connected to a pad for use in a normal operation mode, via an inverter or the like.

11. A device as claimed in any preceding claim, wherein the said first and second output circuitries include a pair of data output buses (DO; $\overline{DO}$), and a data output buffer ($Q_{11}$, $Q_{12}$) connected to said data output buses (DO, $\overline{DO}$); and wherein the connections within the first and second output circuitries are such that "true" output signals from different data output circuits are transmitted simultaneously onto one (DO) of the pair of data output buses, and "complementary" output signals from those different data output circuits are transmitted simultaneously onto the outer ($\overline{DO}$) of the pair of data output buses.

**Patentansprüche**

1. Dynamische Halbleiterspeichervorrichtung mit einer Vielzahl von separaten Blöcken (1-1, 1-2) von Speicherzellen, welche Blöcke mit entsprechenden Schreibschaltungen (3-1, 3-2) zum Schreiben von Daten in jene Blöcke und mit entsprechenden Datenausgangsschaltungen (4-1, 4-2) zum Speichern von Daten, die von jenen Blöcken ausgelesen werden, versehen sind, welche Datenausgangsschaltungen jeweils "wahr"-Ausgangssignalleitungen ($D_1$, $D_2$) und

entsprechende "komplementäre" Ausgangssignalleitungen ($\overline{D}_1$, $\overline{D}_2$) haben; dadurch gekennzeichnet, daß

selektiv betreibbare simultane Schreibfreigabeschaltungen (TP1, $R_3$, $Q_{31}$—$Q_{34}$; TP1', $R_3$, $Q_{51}$ bis $Q_{56}$) mit den genannten Schreibschaltungen (3-1, 3-2) verbunden sind, um zu bewirken, daß entsprechende Schreiboperationen dadurch simultan auf den genannten Blöcken (1-1, 1-2) der Speicherzellen durchgeführt werden, um bei einem Testbetriebsmodus der Vorrichtung, dieselben Testdaten in jeden der genannten Blöcke (1-1, 1-2) zu schreiben, und daß

erste Ausgangsschaltungen ($Q_{35}$, $Q_{37}$, TB, $R_4$, TP2; $Q_{61}$, $Q_{62}$, TB, $R_4$, TP2'; $Q_{81}$, $Q_{73}$, TB, $R_4$, TP2; $Q_5$, $Q_8$, DO), die verbunden sind, um durch die genannten "wahr"-Ausgangssignalleitungen ($D_1$, $D_2$) gesteuert zu werden, und die zweiten Ausgangsschaltungen ($Q_{36}$, $Q_{38}$, $\overline{TB}$, $R_5$, TP3; $Q_{63}$, $Q_{64}$, $\overline{TB}$, $R_5$, TP3'; $Q_{82}$, $Q_{84}$, $\overline{TB}$; $R_5$, TP3; $Q_6$, $Q_9$, $\overline{DO}$), die verbunden sind, um von den genannten "komplementären" Ausgangssignalleitungen ($\overline{D}_1$, $\overline{D}_2$) gesteuert zu werden, bei einem Testbetriebsmodus der Vorrichtung, in Abhängigkeit von einem simultanen Auslesen der Testdaten von den genannten Blöcken betreibbar sind, um jeweilige Vergleiche drchzuführen,

(a) von den Pegeln der "wahr"-Ausgangssignalleitungen ($D_1$, $D_2$), welche die jeweiligen Blöcke (1-1, 1-2) betreffen, und

(b) von den Pegeln der "komplementären" Ausgangs- ($\overline{D}_1$, $\overline{D}_2$) -Signalleitungen, die die entsprechenden Blöcke (1-1, 1-2) betreffen,

und betreibbar sind, um die Ergebnisse der jeweiligen Vergleiche als erste und zweite Logikpegelausgänge zu liefern, welche voneinander verschieden sind, wenn beide Vergleiche anzeigen, daß Daten, wie sie von den jeweiligen Blöcken (1-1, 1-2) ausgelesen wurden, identisch sind, welche jedoch dieselben sind, wenn einer der Vergleiche einen Unterschied zwischen den Daten anzeigt, wie sie von den entsprechenden Blöcken (1-1, 1-2) ausgelesen wurden.

2. Vorrichtung nach Anspruch 1, mit einem Eingangsdatenpuffer (2), um aus einem primären Eingangsdatensignal ($_TD_{in}$), von einem TTL-Pegel, ein erstes MOS-Pegel-Datensignal ($D_{in}$) und ein zweites MOS-Pegel-Datensignal ($\overline{D}_{in}$), welches invers zu dem ersten ist, abzuleiten, einer ersten Mehrzahl von Transfergatekomponenten ($Q_1$, $Q_3$), die durch entsprechende Adreßsignale ($A_0$, $\overline{A}_0$) betätigbar sind, und zum Liefern des genannten ersten MOS-Pegel-Datensignals ($D_{in}$) jeweils mit den genannten Schreibschaltungen (3-1, 3-2) verbunden sind, und einer zweiten Mehrzahl von Transfergatekomponenten ($Q_2$, $Q_4$), die jeweils durch die genannten Adreßsignale ($A_0$, $\overline{A}_0$) betätigbar sind, verbunden sind, um das genannte zweite MOS-Pegel-Datensignal ($\overline{D}_{in}$) an die genannten Schreibschaltungen (3-1, 3-2) zu liefern.

3. Vorrichtung nach Anspruch 2, bei der die genannte simultane Schreibfreigabeschaltung erste Hilfstransfergateeinrichtungen ($Q_{31}$, $Q_{33}$) umfaßt, die parallel mit der genannten ersten Vielzahl von Transfergatekomponenten ($Q_1$, $Q_3$) verbunden sind, und zweite Hilfstransfergateeinrichtungen ($Q_{32}$, $Q_{34}$), die parallel zu der genannten zweiten Vielzahl von Transfergatekomponenten ($Q_2$, $Q_4$) verbunden sind, und selektiv betreibbare Betätigungseinrichtungen (TP1, $R_3$), die mit den genannten ersten und zweiten Hilfstransfergateeinrichtungen ($Q_{31}$—$Q_{34}$) verbunden sind, um diese simultan zu betätigen.

4. Vorrichtung nach Anspruch 3, bei der die genannten selektiv betreibbaren Betätigungseinrchtungen eine Pull-Down-Einrichtung ($R_3$) umfassen, die mit einem Prüfanschlußfleck (TP1) verbunden ist, der mit den genannten ersten und zweiten Transfergateeinrichtungen ($Q_{31}$—$Q_{34}$) so verbunden ist, daß auf diese ein Betätigungspotential über den genannten Prüfanschlußfleck (TP1) aufgebracht werden kann.

5. Vorrichtung nach Anspruch 1, mit einem Eingangsdatenpuffer (2) zum Empfangen eines Eingangsdatensignals ($_TD_{in}$) von einem TTL-Pegel und zum Erzeugen eines Eingangsdatensignals ($D_{in}$) von einem MOS-Pegel und dessen invertierten Signals ($\overline{D}_{in}$); und einer Vielzahl von Transfergateeinrichtungen ($Q_1$—$Q_4$), die jeweils zwischen dem genannten Eingangspuffer (2) und einer der genannten Schreibschaltungen (3-1, 3-2) eingefügt sind; bei welcher die genannten simultanen Schreibfreigabeschaltungen einen Prüfanschlußfleck (TP1') umfassen; einer Pull-down-Einrichtung ($R_3$) mit dem genannten Prüfanschlußfleck (TP1') verbunden ist; und einer Vielzahl von NAND-Gattereinrichtungen ($Q_{51}$—$Q_{53}$, $Q_{54}$—$Q_{56}$), die jeweils einen Eingang, der mit dem genannten Prüfanschlußfleck (TP1') verbunden ist, einen Eingang zum Empfang eines entsprechenden ($A_0$, $\overline{A}_0$) von Adreßsignalen, und einen Ausgang, der mit einer der genannten Transfergateeinrichtungen ($Q_1$—$Q_4$) verbunden ist, haben, wodurch die genannten Transfergateeinrichtung ($Q_1$—$Q_4$) aktiviert werden.

6. Vorrichtung nach einem der vorhergehenden Ansprüche, bei der die genannten ersten und zweiten Ausgangsschaltungen jeweils umfassen:

einen Prüfanschlußfleck (TP2, TP3);

eine Pull-up-Einrichtung ($R_4$; $R_5$), die mit dem genannten Prüfanschalußfleck (TP2; TP3) und mit einem ersten Energieversorgungsanschluß ($V_{cc}$) verbunden ist; und

Transfergateeinrichtungen ($Q_{35}$, $Q_{37}$; $Q_{36}$, $Q_{38}$), die mit dem Prüfanschlußfleck (TP2, TP3) und mit einem zweiten Energieversorgungsanschluß (GND) verbunden sind;

und bei der die Transfergateeinrichtung ($Q_{35}$, $Q_{37}$) der ersten Ausgangsschaltung durch die genannten "wahr"-Ausgangssignalleitungen ($D_1$, $D_2$) und die Transfergateeinrichtung ($Q_{36}$, $Q_{38}$) der zweiten Ausgangsschaltung durch die genannten "komplementären" Ausgangssignalleitungen ($\overline{D}_1$, $\overline{D}_2$) gesteuert werden.

7. Vorrichtung nach einem der Ansprüche 1 bis 5, bei der die genannten ersten und zweiten Ausgangsschaltungen jeweils umfassen:

einen Prüfanschlußfleck (TP2', TP3');

einen Pull-up-Einrichtung ($R_4$; $R_5$), die mit dem

Prüfanschlußfleck (TP2'; TP3') und mit einem ersten Energieversorgungsanschluß ($V_{CC}$) verbunden ist; und

Transfergateeinrichtungen ($Q_{61}$, $Q_{62}$; $Q_{63}$, $Q_{64}$), die mit dem genannten Prüfanschlußfleck (TP2'; TP3') und mit einem zweiten Energieversorgungsanschluß (GND) verbunden sind und eine Vielzahl von Gates ($Q_{61}$, $Q_{62}$; $Q_{63}$, $Q_{64}$) in Reihe umfassen;

und bei der die Transfergateeinrichtung ($Q_{61}$, $Q_{62}$) der ersten Ausgangsschaltung durch die genannten "wahr"-Ausgangssignalleitungen ($D_1$, $D_2$) gesteuert werden, und die Transfergateeinrichtungen ($Q_{63}$, $Q_{64}$) der zweiten Ausgangsschaltung durch die genannten "komplementären" Ausgangssignalleitungen ($\overline{D}_1$, $\overline{D}_2$ gesteuert werden.

8. Vorrichtung nach einem der Ansprüche 1 bis 5, bei der die genannten ersten und zweiten Ausgangsschaltungen jeweils umfassen:

einen ersten Prüfanschlußfleck (TP2; TP3);

eine Pull-up-Einrichtung ($R_4$; $R_5$), die mit dem Prüfanschlußfleck ($TP_2$, $TP_3$) und mit einem ersten Energieversorgungsanschluß ($V_{CC}$) verbunden ist;

und Transfergateeinrichtungen ($Q_{81}$, $Q_{83}$; $Q_{86}$, $Q_{88}$; $Q_{82}$, $Q_{84}$, $Q_{87}$, $Q_{89}$), die mit dem Prüfanschlußfleck (TP2; TP3) verbunden sind;

und bei der die Transfergateeinrichtungen ($Q_{81}$, $Q_{83}$; $Q_{86}$, $Q_{88}$) der ersten Ausgangsschaltung durch die genannten "wahr"-Ausgangssignalleitungen ($D_1$, $D_2$) gesteuert werden, und die Transfergateeinrichtungen ($Q_{82}$, $Q_{84}$; $Q_{87}$, $Q_{89}$) der zweiten Ausgangsschaltung durch die genannten "komplementären" Ausgangssignalleitungen ($\overline{D}_1$, $\overline{D}_2$) gesteuert werden, und

bei der ferner selektive Aktivierungseinrichtungen (TP4, $R_6$, $Q_{85}$; TP5, $R_7$, $Q_{90}$) vorgesehen sind, die gemeinsam mit Transfergateeinrichtungen der ersten und zweiten Ausgangsschaltung und mit einem zweiten Energieversorgungsanschluß (GND) verbunden sind, um selektive jene Transfergateeinrichtungen zu aktivieren.

9. Vorrichtung nach Anspruch 8, bei der die selektive Aktivierungseinrichtung einen Prüfanschlußfleck (TP4, TP5), Pull-down-Einrichtungen ($R_6$, $R_7$), die mit dem Prüfanschlußfleck (TP4, TP5) verbunden sind, und eine Transfergate umfassen, das mit dem Prüfanschlußfleck (TP4, TP5) und zwischen dem zweiten Energieversorgungsanschluß (GND) und den Transfergateeinrichtungen der ersten und zweiten Ausgangsschaltungen verbunden ist.

10. Vorrichtung nach Anspruch 4, 5, 6, 7, 8, oder 9, bei der jeder Prüfanschlußfleck mit einem Anschlußfleck zur Verwendung in einem normalen Betriebsmodus über einen Inverter oder dergleichen verbunden ist.

11. Vorrichtung nach einem der vorhergehenden Ansprüche, bei der die genannten ersten und zweiten Ausgangsschaltungen eine Paar von Datenausgangsbussen (DO; $\overline{DO}$) umfassen, und ein Datenausgangspuffer ($Q_{11}$, $Q_{12}$) mit den genannten Datenausgangsbussen (DO, $\overline{DO}$) verbunden ist; und bei der die Verbindungen mit den ersten und zweiten Ausgangsschaltungen derart sind, daß "wahr"-Ausgangssignale von verschiedenen Datenausgangsschaltungen simultan auf einen (DO) des Paares von Datenausgangsbussen übertragen werden, und 'komplementäre" Ausgangssignale von jenen verschiedenen Datenausgangsschaltungen simultan auf den anderen ($\overline{DO}$) des Paares von Datenausgangsbussen übertragen werden.

**Revendications**

1. Dispositif de mémoire dynamique à semiconducteur comprenant un ensemble de blocs séparés (1-1, 1-2) de cellules de mémoire, ces blocs étant pourvus de circuits d'écriture respectifs (3-1, 3-2) pour écrire des données dans ces blocs, et de circuits de sortie de données respectifs (4-1, 4-2) pour mémoriser des données lues dans ces blocs, ces circuits de sortie de données comportant des lignes de signaux de sortie "vrais" ($D_1$, $D_2$) et des lignes de signaux de sortie "complémentaires" ($\overline{D}_1$, $\overline{D}_2$); caractérisé en ce que

des circuits de validation d'écriture simultanée pouvant être mis en fonctionnement sélectivement (TP1, $R_3$, $Q_{31}$—$Q_{34}$; TP1', $R_3$, $Q_{51}$ à $Q_{56}$) sont connectés aux circuits d'écriture (3-1, 3-2) pour faire en sorte que des opérations d'écriture respectives soient exécutées par ceux-ci simultanément sur les blocs de cellules de mémoire (1-1, 1-2), pour écrire les mêmes données de test dans chacun des blocs (1-1, 1-2), dans un mode d'opération de test du dispositif, et en ce que

des premiers circuits de sortie ($Q_{35}$, $Q_{37}$, TB, $R_4$, TP2; $Q_{61}$, $Q_{62}$, TB, $R_4$, TP2'; $Q_{81}$, $Q_{83}$, TB, $R_4$, TP2; $Q_5$, $Q_8$, DO), connectés pour être commandés par les lignes de signaux de sortie "vrais" ($D_1$, $D_2$), et des deuxièmes circuits de sortie ($Q_{36}$, $Q_{38}$, $\overline{TB}$, $R_5$, TP3; $Q_{63}$, $Q_{64}$, $\overline{TB}$, $R_5$, TP3'; $Q_{82}$, $Q_{84}$, $\overline{TB}$, $R_5$, TP3; $Q_6$, $Q_9$, $\overline{DO}$), connectés pour être commandés par les lignes de signaux de sortie "complémentaires" ($\overline{D}_1$, $\overline{D}_2$), peuvent être mis en fonctionnement dans le mode d'opération de test du dispositif en réponse à la lecture simultanée des données de test dans les blocs pour effectuer des comparaisons respectives

(a) des niveaux des lignes de signaux de sortie "vrais" ($D_1$, $D_2$) relatifs aux blocs respectifs (1-1, 1-2) et

(b) des niveaux des lignes de signaux de sortie "complémentaires" ($\overline{D}_1$, $\overline{D}_2$) relatifs aux blocs respectifs (1-1, 1-2),

et peuvent être mis en fonctionnement pour fournir les résultats des comparaisons respectives comme signaux de sortie de premier et deuxième niveaux logiques, qui diffèrent quand les deux comparaisons indiquent que les données telles que lues dans les blocs respectifs (1-1, 1-2) sont identiques. mais qui sont identiques quand une comparaison indique une différence entre les données telles que lues dans les blocs respectifs (1-1, 1-2).

2. Dispositif selon la revendication 1, incluant un tampon d'entrée de données (2) pour dériver d'un signal de données d'entrée principal ($_T D_{in}$), d'un niveau de logique à transistor-transistor TTL, un premier signal de données de niveau à métal-oxyde-semiconducteur MOS ($D_{in}$) et un deuxième signal de données de niveau MOS ($\bar{D}_{in}$) qui est l'inverse du premier, un premier ensemble de composants de porte de transfert ($Q_1$, $Q_3$) qui peuvent être mis en fonctionnement par des signaux d'adresse respectifs ($A_0$, $\bar{A}_0$) et sont connectés pour fournir le premier signal de données de niveau MOS ($D_{in}$) respectivement aux circuits d'écriture (3-1, 3-2), et un deuxième ensemble de composants de porte de transfert ($Q_2$, $Q_4$) qui peuvent être mis en fonctionnement respectivement par les signaux d'adresse ($A_0$, $\bar{A}_0$) et sont connectés pour founir le deuxième signal de données de niveau MOS ($\bar{D}_{in}$) aux circuits d'écriture (3-1, 3-2).

3. Dispositif selon la revendication 2, dans lequel les circuits de validation d'écriture simultanée comprennent des premiers moyens à porte de transfert auxiliaires ($Q_{31}$, $Q_{33}$), connectés en parallèle avec le premier ensemble de composants de porte de transfert ($Q_1$, $Q_3$), des deuxièmes moyens à porte de transfert auxiliaires ($Q_{32}$, $Q_{34}$), connectés en parallèle avec le deuxième ensemble de composants de porte de transfert ($Q_2$, $Q_4$), et un moyen de mise à l'état actif pouvant être mis en fonctionnement sélectivement (TP1, $R_3$) connecté aux premiers et deuxièmes moyens à porte de transfert auxiliaires ($Q_{31}$—$Q_{34}$) pour les rendre actifs simultanément.

4. Dispositif selon la revendication 3, dans lequel le moyen de mise à l'état actif pouvant être mis en fonctionnement sélectivement comprend un moyen chuteur ($R_3$) connecté à un plot de test (TP1) qui est connecté aux premier et deuxième moyens à porte de transfert ($Q_{31}$—$Q_{34}$), de sorte qu'un potentiel de mise à l'état actif peut lui être appliqué au moyen du plot de test (TP1).

5. Dispositif selon la revendication 1, incluant un tampon d'entrée de données (2) pour recevoir un signal de données d'entrée ($_T D_{in}$) d'un niveau TTL et pour engendrer un signal de données d'entrée ($D_{in}$) d'un niveau MOS et son signal inversé ($\bar{D}_{in}$); et un ensemble de moyens à porte de transfert ($Q_1$—$Q_4$), chacun étant relié entre le tampon d'entrée de données (2) et un des circuits d'écriture (3-1, 3-2); dans lequel les circuits de validation d'écriture simultanée comprennent un plot de test (TP1'); un moyen chuteur ($R_3$) connecté au plot de test (TP1'); et un ensemble de moyens à porte NON-ET ($Q_{51}$—$Q_{53}$, $Q_{54}$—$Q_{56}$), chacun comportant une entrée connectée au plot de test (TP1'), une entrée pour recevoir le signal respectif ($A_0$, $\bar{A}_0$) des signaux d'adresse, et une sortie connectée à un des moyens à porte de transfert ($Q_1$—$Q_4$), pour rendre ainsi actif les moyens à porte de transfert ($Q_1$—$Q_4$).

6. Dispositif selon l'une quelconque des revendications 1 à 5, dans lequel les premiers et deuxièmes circuits de sortie comprennent chacun:

un plot de test (TP2; TP3);
un moyen de charge ($R_4$; $R_5$) connecté au plot de test (TP2; TP3) et à une première borne de source d'alimentation ($V_{CC}$); et
des moyens à porte de transfert ($Q_{35}$, $Q_{37}$; $Q_{36}$, $Q_{38}$), connectés au plot de test (TP2, TP3) et à une deuxième borne de source d'alimentation (GND);
et, dans lequel, les moyens à porte de transfert ($Q_{35}$, $Q_{37}$) des premiers circuits de sortie sont commandés par les lignes de signaux de sortie "vrais" ($D_1$, $D_2$) et les moyens à porte de transfert ($Q_{36}$, $Q_{38}$) des deuxièmes circuits de sortie sont commandés par les lignes de signaux de sortie "complémentaires" ($\bar{D}_1$, $\bar{D}_2$).

7. dispositif selon l'une quelconque des revendications 1 à 5, dans lequel les premiers et deuxièmes circuits de sortie comprennent chacun:

un plot de test (TP2'; TP3');
un moyen de charge ($R_4$; $R_5$) connecté au plot de test (TP2'; TP3') et à une première borne de source d'alimentation ($V_{CC}$); et
des moyens à porte de transfert ($Q_{61}$, $Q_{62}$; $Q_{63}$, $Q_{64}$) connectés au plot de test (TP2'; TP3') et à une deuxième borne de source d'alimentation (GND), et comprenant un ensemble de portes ($Q_{61}$, $Q_{62}$; $Q_{63}$, $Q_{64}$) en série;
et, dans lequel, les moyens à porte de transfert ($Q_{61}$, $Q_{62}$) des premiers circuits de sortie sont commandés par les lignes de signaux de sortie "vrais" ($D_1$, $D_2$) et les moyens à porte de transfert ($Q_{63}$, $Q_{64}$) des deuxièmes circuits de sortie sont commandés par les lignes de signaux de sortie "complémentaires" ($\bar{D}_1$, $\bar{D}_2$).

8. Dispositif selon l'une quelconque des revendications 1 à 5, dans lequel les premiers et deuxièmes circuits de sortie comprennent chacun:

un plot de test (TP2; TP3);
un moyen de charge ($R_4$; $R_5$) connecté au plot de test (TP2, TP3) et à une premier borne de source d'alimentation ($V_{CC}$);
et des moyens à porte de transfert ($Q_{81}$, $Q_{83}$; $Q_{86}$, $Q_{88}$; $Q_{82}$, $Q_{84}$; $Q_{87}$, $Q_{89}$) connectés au plot de test (TP2, TP3);
et, dans lequel, les moyens à porte de transfert ($Q_{81}$, $Q_{83}$; $Q_{86}$, $Q_{88}$) des premiers circuits de sortie sont commandés par les lignes de signaux de sortie "vrais" ($D_1$, $D_2$) et les moyens à porte de transfert ($Q_{82}$, $Q_{84}$; $Q_{87}$, $Q_{89}$) des deuxièmes circuits de sortie sont commandés par les lignes de signaux de sortie "complémentaires" ($\bar{D}_1$, $\bar{D}_2$), et
dans lequel, on a en outre prévu un moyen de mise à l'état actif sélective (TP4, $R_6$, $Q_{85}$; TP5, $R_7$, $Q_{90}$) connecté en commun aux moyens à porte de transfert des premiers et deuxièmes circuits de sortie et à une deuxième borne de source d'alimentation (GND), pour rendre sélectivement actifs les moyens à porte de transfert.

9. Dispositif selon la revendication 8, dans lequel le moyen de mise à l'état actif sélective comprend un plot de test (TP4, TP5), un moyen chuteur ($R_6$, $R_7$) connecté au plot de test (TP4, TP5), et une porte de tranfert connectée au plot de test (TP4, TP5) et entre la deuxième borne de source d'alimentation (GND) et les moyens à porte de transfert des premiers et deuxièmes circuits de sortie.

10. Dispositif selon l'une quelconque des revendications 4 à 9, dans lequel chaque plot de test est connecté à un plot servant dans un mode d'opération normale, par l'intermédiaire d'un inverseur ou l'équivalent.

11. Dispositif selon l'une quelconque des revendications 1 à 10, dans lequel les premiers et deuxièmes circuits de sortie comprennent une paire de bus de sortie de données (DO; $\overline{DO}$), et un tampon de sortie de données ($Q_{11}$, $Q_{12}$) connecté aux bus de sortie de données (DO, $\overline{DO}$); et dans lequel les connexions à l'intérieur des premiers et deuxièmes circuits de sortie sont tels que les signaux de sortie "vrais" provenant des différents circuits de sortie de données sont transmis simultanément sur un (DO) de la paire de bus de sortie de données, et les signaux de sortie "complémentaires" provenant des différents circuits de sortie de données sont transmis simultanément sur l'autre ($\overline{DO}$) de la paire de bus de sortie de données.

# Fig. 1

# Fig. 2

$DB_1 (DB_2)$      $\overline{DB}_1 (\overline{DB}_2)$

$\phi_{R1}$

$Q_{21}$    $Q_{22}$

4-1(4-2)

$N_1$   $N_2$

$Q_{23}$    $Q_{24}$

$D_1 (D_2)$      $\overline{D}_1 (\overline{D}_2)$

# Fig. 10

P

INTERNAL CIRCUIT

$Q_{101}$

$Q_{102}$

$Q_{103}$    TP1

$R_8$

$R_3$

# Fig. 3

## Fig. 4

| D₁ | D̄₁ | D₂ | D̄₂ | TP2 | TP3 |
|----|-----|----|-----|-----|-----|
| H | L | H | L | L | H |
| L | H | H | L | L | L |
| H | L | L | H | L | L |
| L | H | L | H | H | L |

## Fig. 5

# Fig. 6

# Fig. 7

| D₁ | D̄₁ | D₂ | D̄₂ | TP2' | TP3' |
|----|-----|----|-----|------|------|
| H | L | H | L | L | H |
| L | H | H | L | H | H |
| H | L | L | H | H | H |
| L | H | L | H | H | L |

# Fig. 8

Fig. 9